Europäisches Patentamt

European Patent Office

Office européen des brevets

(11) Numéro de publication: **0 019 506**
**B1**

(12) **FASCICULE DE BREVET EUROPEEN**

(45) Date de publication du fascicule du brevet: **02.03.83**

(21) Numéro de dépôt: **80400550.2**

(22) Date de dépôt: **23.04.80**

(51) Int. Cl.³: **G 06 G  7/14,** H 03 H  15/02,
G 11 C  19/28

(54) **Dispositif à transfert de charges de soustraction et de génération de quantités de charges.**

(30) Priorité: **04.05.79 FR  7911315**

(43) Date de publication de la demande:
**26.11.80 Bulletin 80/24**

(45) Mention de la délivrance du brevet:
**02.03.83 Bulletin 83/9**

(84) Etats contractants désignés:
**DE GB NL**

(56) Documents cités:
**FR - A - 2 365 245**
**FR - A - 2 386 942**
**US - A - 4 047 051**

**IBM TECHNICAL DISCLOSURE BULLETIN, vol.
18, no. 9, février 1976 NEW YORK (US) D. L.
CRITCHLOW et al.: "Magnitude Differencing
Circuit", pages 3071—3072.**

(73) Titulaire: **THOMSON-CSF**
**173, Boulevard Haussmann**
**F-75379 Paris Cedex 08 (FR)**

(72) Inventeur: **Berger, Jean-Luc**
**"THOMSON-CSF" - SCPI 173, Bld Haussmann**
**F-75360 Paris Cedex 08 (FR)**
Inventeur: **Coutures, Jean-Louis**
**"THOMSON-CSF" - SCPI 173, Bld Haussmann**
**F-75360 Paris Cedex 08 (FR)**

(74) Mandataire: **Benichou, Robert et al,**
**THOMSON-CSF SCPI 173 bld Haussmann**
**F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Dispositif à transfert de charges de soustraction et de génération de quantités de charges

La présente invention concerne un dispositif à transfert de charges de soustraction et de génération de quantités de charges assurant la soustraction à une quantité de charges de référence de n quantités decharges et la génération d'une quantité de charges équivalente aux n quantités de charges.

Lors du traitement par transfert de charges de signaux analogiques, il est souvent nécessaire d'effectuer la soustraction entre deux signaux. Dans l'art antérieur, on convertit généralement les charges en tension puis on effectue la soustraction sur les tensions. On ré-injecte ensuite dans le système à transfert de charges une quantité de charges correspondant au résultat de la soustraction.

Les conversions de charges en tensions et vice-versa présentent l'inconvénient d'être peu linéaires et de gain difficilement reproductible. D'autre part, les dispositifs permettant de réaliser les conversions et la soustraction sur les tensions sont généralement encombrants et de consommation élevée.

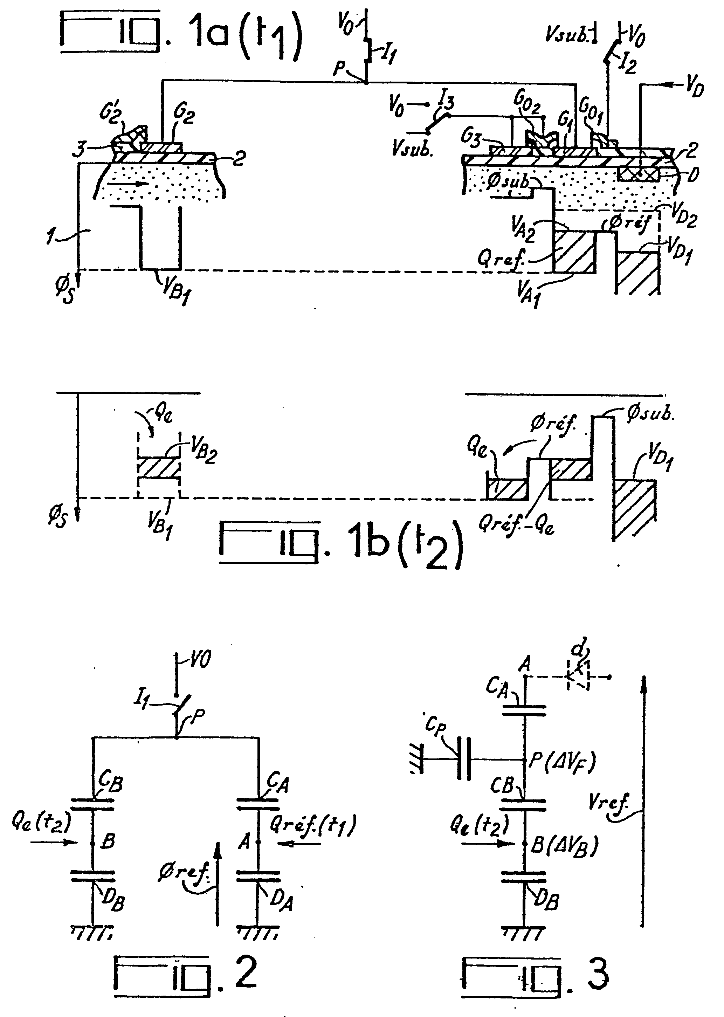

On connait par la demande de brevet français N° 77.27749, publiée sous le n° 2.365.245, un dispositif à transfert de charges classique dans lequel l'une des électrodes de stockage, qui porte la référence 42 sur la figure 1, est successivement portée à un potentiel constant et à un potentiel flottant. La lecture de la tension aux bornes de l'électrode 42 est réalisée par un transistor à effet de champ 48.

Alors que l'électrode 42 est à un potentiel flottant, le départ de la quantité de charges $Q_{n-1}$ de l'électrode 42 puis l'arrivée de la quantité de charges $Q_n$ permet d'obtenir en sortie du transistor 48 la tension $V_o$ telle que:

$$V_o = V - Q_{n-1}/C_t + Q_n/C_t.$$

L'électrode 42 est ensuite portée au potentiel constant qui rétablit la tension V en sortie du transistor 48 avant que commence une nouvelle soustraction.

On constate donc que dans cette demande de brevet on effectue la soustraction entre deux tensions.

La présente invention concerne un dispositif réalisant directement la soustraction sur les quantités de charges.

Ce dispositif présente l'avantage d'être facilement intégrable dans un système à transfert de charges plus complexe. Il permet d'obtenir avec une bonne précision une quantité de charges égale à la différence entre une quantité de charges de référence et n quantités de charges. Dans un mode de réalisation préféré, ce dispositif nécessite une seule tension de polarisation des électrodes de stockage et de transfert, mise à part la tension de référence du substrat, ce qui accroît sa simplicité et sa précision.

Le dispositif selon l'invention assure également avec une bonne précision la génération d'une quantité de charges équivalente au n quantités de charges que l'on soustrait à la quantité de charges de référence.

Le dispositif selon l'invention est caractérisé en ce qu'il comporte dans un substrat où les capacités de déplétion sont très inferieure aux capacités d'oxyde:

— une première électrode de stockage connectée électriquement en un point P à n autres électrodes de stockage;

— des moyens assurant l'injection sous la première électrode de stockage de la quantité de charges de référence, avant l'arrivée des charges sous les n électrodes de stockage et alors que le point P est à une tension constante;

— des moyens assurant le maintien d'un potentiel de surface constant sous la première électrode de stockage, lors de l'arrivée des charges sous les n électrodes de stockage et alors que le point P est laissé flottant, et des moyens assurant l'évacuation des charges en surplus, ce qui entraîne donc la génération d'une quantité de charges équivalente aux n quantités de charges qui sont arrivées sous les n électrodes de stockage et ce qui entraîne que la quantité de charges restant sous la première électrode de stockage résulte de la soustraction entre la quantité de charges de référence et entre les n quantités de charges.

D'autres objets, caractéristiques et résultats de l'invention ressortiront de la description suivante, donnée à titre d'exemple non limitatif et illustrée par les figures annexées qui représentent:

— les figures 1a et 1b, une vue en coupe transversale d'un mode de réalisation du dispositif selon l'invention et deux schémas illustrant son fonctionnement;

— les figures 2 et 3, des schémas électriques équivalents au mode de réalisation du dispositif selon l'invention représenté sur la figure 1a.

Sur les différentes figures, les mêmes repères désignent les mêmes éléments, mais, pour des raisons de clarté, les cotes et proportions des différents éléments n'ont pas été respectées.

La figure 1a représente une vue en coupe transversale, selon la direction de propagation des charges, d'un mode de réalisation du dispositif selon l'invention.

Un substrat semi-conducteur 1, en silicium de type P dans l'exemple, est recouvert d'une couche isolante 2, en oxyde de silicium dans l'exemple. Sur cette couche isolante 2, alternent des électrodes de stockage et de transfert des charges qui sont disposées sensiblement normalement à la direction de propagation des charges. Les électrodes de transfert sont déposées sur une surépaisseur d'isolant 3.

Ainsi qu'il est connu, cette disposition a une double fonction, d'une part assurer la continuité des potentiels créés dans le semi-conducteur 1, et d'autre part imposer un sens de transfert unique pour les porteurs de charge.

Cette structure comportant une surépaisseur d'isolant peut être remplacée par un surdopage du substrat, par implantation d'ions, assurant les mêmes fonctions.

Sur la figure 1a, une première électrode de stockage $G_1$ est connectée électriquement par une liaison métallique extérieure au substrat et généralement en aluminium à une seule électrode de stockage $G_2$.

L'électrode de stockage $G_2$ fait partie d'un registre à transfert de charges dans lequel sont transférées la ou les quantités de charges à soustraire à une quantité de charges de référence $Q_{réf}$. On a seulement représenté sur la figure 1a l'électrode de stockage $G_2$ de ce registre et l'électrode de transfert $G'_2$ qui précède $G_2$, selon le sens de transfert des charges indiqué par une flèche.

La première électrode de stockage $G_1$ est entourée par deux électrodes de transfert $G_{01}$ et $G_{02}$. L'électrode de transfert $G_{01}$ est suivie d'une diode d'injection de charges D qui est constituée par une diffusion de type $N^+$. L'électrode de transfert $G_{02}$ est suivie d'une électrode de stockage $G_3$.

Le point P peut être relié à une tension constante $V_0$, il peut aussi être laissé flottant, c'est-à-dire qu'il peut n'être relié à aucune source de tension. L'interrupteur $I_1$, sur la figure 1a, représente sumboliquement les deux possibilités de polarisation du point P.

Les grilles $G_{01}$, $G_{02}$, et $G_3$ peuvent être connectées à la tension constante $V_0$ ou à une tension inférieure à $V_0$ qui peut être la tension de polarisation du substrat $V_{sub}$. Ces deux possibilités de polarisation sont représentées symboliquement par l'interrupteur $I_2$ relié à $G_{01}$ et par l'interrupteur $I_3$ relié à $G_{02}$ et $G_3$.

Dans la pratique, les interrupteurs $I_1$, $I_2$ et $I_3$ sont généralement constitués par un ou plusieurs transistors MOS.

La diode d'injection de charges D reçoit une tension de polarisation $V_D$.

Les figures 1a et 1b comportent également deux schémas illustrant le fonctionnement du dispositif selon l'invention. Ces schémas représentent l'évolution du potentiel de surface $\phi_S$ dans le substrat 1. Les zones hachurées indiquent la présence de porteurs minoritaires.

La figure 1a représente les différents potentiels de surface dans le substrat au temps $t_1$. Au temps $t_1$, les interrupteurs $I_1$, $I_2$ et $I_3$ sont dans la position indiquée sur la figure 1a.

Au temps $t_1$, le point P est à la tension constante $V_0$ et le potentiel de surface sous les électrodes de stockage $G_1$ et $G_2$, soient $V_{A1}$ et $V_{B1}$ ces potentiels, est le même.

L'électrode de transfert $G_{01}$ est à la tension constante $V_0$ par l'interrupteur $I_2$. Un potentiel de surface de référence $\phi_{réf}$ est ainsi établi sous cette électrode.

Les électrodes $G_{02}$ et $G_3$ sont portées par $I_3$ à la tension de polarisation du substrat $V_{sub}$. Un faible potentiel de surface $\phi_{sub}$ est ainsi créé sous $G_{02}$ et $G_3$.

Au temps $t_1$, le signal $V_D$ appliqué à la diode D passe de $V_{D1}$ à $V_{D2}$ puis retourne à $V_{D1}$, les tensions $V_{D1}$ et $V_{D2}$ étant respectivement supérieure et inférieure au potentiel de surface $\phi_{réf}$ sous l'électrode de transfert $G_{01}$.

Le niveau des charges sous $G_1$, $G_{01}$ et D lorsque la diode D reçoit la tension $V_{D2}$ est représenté en trait discontinu sur la figure 1a. Lorsque la diode D reçoit à nouveau la tension $V_{D1}$, le niveau des charges sous l'électrode $G_1$ diminue et une quantité de charges dite de référence $Q_{réf}$ se trouve stockée sous l'électrode $G_1$. Le potentiel de surface sous l'électrode $G_1$ est fixé à la valeur $V_{A2}$ égale à $\phi_{réf}$ par l'électrode de transfert $G_{01}$.

La figure 1b représente les divers potentiels de surface dans le substrat au temps $t_2$. Au temps $t_2$, les interrupteurs $I_1$, $I_2$ et $I_3$ sont dans la position inverse à celle qui est représentée sur la figure 1a.

Au temps $t_2$, l'interrupteur $I_1$ est ouvert et le point P est donc laissé flottant.

L'interrupteur $I_2$ est relié à la tension de polarisation du substrat $V_{sub}$. Le potentiel de surface sous l'électrode de transfert $G_{01}$ est donc fixé à $\phi_{sub}$.

L'interrupteur $I_3$ est relié à la tension constante $V_0$. Le potentiel de surface sous l'électrode de transfert $G_{02}$ est donc fixé à $\phi_{réf}$. Le potentiel de surface sous l'électrode de stockage $G_3$ est fixé, à cause de la différence d'épaisseur de l'oxyde sur lequel les électrodes $G_{02}$ et $G_3$ sont déposées, à un niveau supérieur à $\phi_{réf}$.

Lors de l'arrivée d'une quantité de charges $Q_e$ sous l'électrode de stockage $G_2$, le potentiel de surface sous cette électrode varie et passe de $V_{B1}$ à $V_{B2}$. Le point P étant laissé flottant, cette variation de potentiel de surface est transmise à l'électrode de stockage $G_1$. Le potentiel de surface sous l'électrode de stockage $G_1$ est fixé au niveau $\phi_{réf}$ par l'électrode de transfert $G_{02}$. Il y a donc transfert d'une quantité de charges de $G_1$ sous l'électrode de stockage $G_3$. On montre que la quantité de charges transférée sous $G_3$ égale $Q_e$, est donc, que la quantité de charges restant sous $G_1$ égale $Q_{réf} - Q_e$.

Le mode de réalisation du dispositif selon l'invention représenté sur la figure 1a permet donc de générer sous l'électrode de stockage $G_3$ une quantité de charges équivalente à celle qui arrive sous l'électrode $G_2$. Il est également possible d'éliminer la quantité de charges $Q_e$ en surplus en l'envoyant sous la diode D. Pour ce la, il suffit de maintenir l'électrode de transfert

$G_{02}$ à la tension $V_{sub}$ et l'électrode de transfert $G_{01}$ à la tension $V_0$ pendant les temps $t_1$ et $t_2$.

Pour que le potentiel de surface sous l'électrode $G_1$ soit maintenu constant lors de l'arrivée de la quantité de charges $Q_e$ sous $G_2$, il est nécessaire que les tensions appliquées, respectivement au temps $t_1$ à l'électrode $G_{01}$ et au temps $t_2$ à l'électrode $G_{02}$ soient égales, ceci dans le cas où une quantité de charges $Q_e$ est transférée sous $G_3$, ou, que la tension appliquée à $G_{01}$, aux temps $t_1$ et $t_2$, soit constante, ceci dans le cas où une quantité de charges $Q_e$ est transférée avec la diode D. Par contre, la tension $V_P$, à laquelle le point P est relié au temps $t_1$, soit $V_P$ cette tension, peut être différente de la tension $V_0$ permettant d'établir le potentiel de référence $\phi_{réf}$ sous l'électrode $G_{01}$. Lorsqu'on prend $V_P$ égal à $V_0$, le dispositif selon l'invention est simplifié et sa précision se trouve augmentée.

La figure 2 représente un schéma électrique équivalent au mode de réalisation du dispositif selon l'invention qui est représenté sur la figure 1a. Les capacités $C_A$ et $C_B$ représentent les capacités d'oxyde des électrodes $G_1$ et $G_2$. Les capacités $D_A$ et $D_B$ représentent les capacités de déplétion des électrodes $G_1$ et $G_2$. Sur le schéma de la figure 2, les capacités $D_A$ et $D_B$ sont reliées à la masse qui constitue la référence dynamique du dispositif selon l'invention. On appelle A et B les points de connexion respectifs des capacités $C_A$ et $D_A$ et des capacités $C_B$ et $D_B$.

Les relations en charges aux points A, B, et P s'écrivent:

— au temps $t_1$, après injection de la quantité de charges de référence $Q_{réf}$ sous $G_1$.

Somme des charges en A=

$$\phi_{réf} \cdot D_A + (\phi_{réf} - V_0) \cdot C_A = Q_{réf}$$

Somme des charges en B=

$$V_{B1} \cdot D_B + (V_{B1} - V_0) \cdot C_B = 0$$

Somme des charges en P=

$$(V_0 - \phi_{réf}) \cdot C_A + (V_0 - V_{B1}) \cdot C_B = Q_P$$

— au temps $t_2$.
Somme des charges en A=

$$\phi_{réf} \cdot D_A + (\phi_{réf} - V_F) \cdot C_A = Q_S$$

Somme des charges en B=

$$= V_{B2} \cdot D_B + (V_{B2} - V_F) \cdot C_B = Q_e$$

Somme des charges en P=

$$= (V_F - \phi_{réf}) \cdot C_A + (V_F - V_{B2}) \cdot C_B = Q_P$$

où $V_F$ et $Q_S$ représentent, au temps $t_2$, après l'arrivée de la quantité de charges $Q_e$ sous $G_2$, la

tension au point P et la quantité de charges restant sous $G_1$.

La résolution des six équations précédentes permet d'établir l'expression de $Q_S$ suivante:

$$Q_S = Q_{réf} - Q_e \cdot \cfrac{1}{1 + \cfrac{D_B}{C_A} + \cfrac{D_B}{C_B}}$$

On constate donc, qu'en considérant la capacité de déplétion $D_B$ très inférieure aux capacités d'oxyde $C_A$ et $C_B$, comme cela est généralement le cas, l'égalité suivante se trouve vérifiée:

$$Q_S = Q_{réf} - Q_e \qquad (1)$$

On a réalisé la soustraction entre la quantité de charges de référence $Q_{réf}$ et la quantité de charges $Q_e$, et donc aussi la génération d'une quantité de charges équivalente à $Q_e$.

Il est possible de diminuer l'importance de la capacité de déplétion $D_B$ par rapport aux capacités d'oxyde $C_A$ et $C_B$ en utilisant un substrat peu dopé, de l'ordre de $5 \cdot 10^{14}$ cm$^{-3}$.

Il est possible d'établir un schéma électrique équivalent au dispositif selon l'invention, et analogue à celui qui est représenté sur la figure 2, dans le cas où n électrodes de stockage $G_{21}$ à $G_{2n}$ sont connectées électriquement au point P à la première électrode de stockage $G_1$. L'écriture des relations en charges permet d'établir que:

$$Q_S = Q_{réf} - \sum_{i=1}^{n} Q_{ei}, \qquad (2)$$

$Q_{ei}$ représentant la quantité de charges arrivant sous une électrode $G_{2i}$ au temps $t_2$. Le dispositif selon l'invention permet donc de réaliser la soustraction entre une quantité de charges de référence $Q_{réf}$ et une quantité de charges

$$\sum_{i=1}^{n} Q_{ei}.$$

Une quantité de charges équivalente aux n quantités de charges $Q_{e1}$ à $Q_{en}$ est également générée.

Comme dans le cas où le dispositif comporte une seule électrode de stockage $G_2$ (relation (1) la relation (2) ne peut s'écrire que lorsque les capacités de déplétion sont négligeables devant celles d'oxyde, ce qui est généralement le cas.

L'écriture des relations en charges au point A, au temps $t_1$, avant et après l'injection de la quantité de charges de référence $Q_{réf}$, permet d'obtenir l'expression de $Q_{réf}$ suivante:

$$Q_{réf} = (\phi_{réf} - V_{A1}) \cdot (C_A + D_A).$$

**0 019 506**

On remarque donc que $Q_{réf}$ est proportionnel à $C_A + D_A$, c'est-à-dire à la surface $S_1$ de l'électrode de stockage $G_1$, ceci pour une valeur $V_0$ donnée. La quantité de charges de référence $Q_{réf}$ doit bien entendu être supérieure à la valeur maximale de

$$\sum_{i=1}^{n} Q_{ei},$$

$V_0$ et $S_1$ doivent être déterminés en tenant compte de cette condition.

La figure 3 représente un autre schéma électrique équivalent au mode de réalisation du dispositif selon l'invention qui est représenté sur la figure 1a. On a représenté au point P la capacité parasite $C_P$ qui est due notamment au recouvrement des électrodes de transfert et de stockage et au transistor MOS qui est connecté au point P remplacer dans la pratique l'interrupteur $I_1$. La diode d, connectée au point A et représentée en trait discontinu, indique que le dispositif selon l'invention ne fonctionne que lorsqu'il y a apport de charges et donc diminution du potentiel de surface sous l'électrode $G_2$.

Les variations de potentiel aux points B et P, $\Delta V_B$ et $\Delta V_F$ s'écrivent:

$$\Delta V_B = \cfrac{Q_e}{D_B + \cfrac{C_B(C_A + C_P)}{C_B + C_A + C_P}}$$

et

$$\Delta V_F = \Delta V_B \cdot \frac{C_B}{C_B + C_A + C_P}$$

Ces relations permettent d'établir la variation de charges au point A:

$$\Delta Q_A = C_A \cdot \Delta V_F = Q_{réf} - Q_S \simeq Q_e \cdot \frac{C_A}{C_A + C_P} \quad (3),$$

où $Q_S$ représente la quantité de charges sous $G_1$ après l'arrivée de $Q_e$ sous $G_2$.

Il faut bien entendu, pour que la relation précédente soit vérifiée, que la capacité de déplétion $D_B$ soit négligeable devant les capacités d'oxyde.

On constate donc en considérant la relation (3) que le dispositif selon l'invention réalise la soustraction entre $Q_{réf}$ et $Q_e$ et la génération de $Q_e$ à condition que la capacité parasite $C_P$ soit négligeable devant la capacité d'oxyde $C_A$. La même condition doit être vérifiée dans le cas d'un dispositif comportant n capacités $G_{21}$ à $G_{2n}$ réliées à $G_1$.

**Revendications**

1. Dispositif à transfert de charges de soustraction et de génération de quantités de charges assurant la soustraction à une quantité de charges de référence de n quantités de charges et la génération d'une quantité de charges équivalente aux n quantités de charges, caractérisé en ce qu'il comporte dans un substrat où les capacités de déplétion sont très inferieures aux capacités d'oxyde:

— une première électrode de stockage ($G_1$) connectée électriquement en un point P à n autres électrodes de stockage ($G_{21} \ldots G_{2n}$);
— des moyens ($G_{01}$, $G_{02}$, D) assurant l'injection sous la première électrode de stockage de la quantité de charges de référence ($Q_{réf}$), avant l'arrivée des charges sous les n électrodes de stockage er alors que le point P est à une tension constante $V_P$;
— des moyens ($G_{01}$, $G_{02}$, $G_3$, D) assurant le maintien d'un potentiel de surface constant ($\phi_{réf}$) sous la première électrode de stockage ($G_1$) lors de l'arrivée des charges ($Q_e$) sous les n électrodes de stockage et alors que le point P est laissé flottant, et des moyens ($G_{01}$, $G_{02}$, $G_2$, D) assurant l'évacuation des charges en surplus, ce qui entraîne donc la génération d'une quantité de charges ($Q_e$) équivalente aux n quantités de charges qui sont arrivées sous les n électrodes de stockage et ce qui entraîne que la quantité de charges ($Q_{réf} - Q_e$) restant sous la première électrode de stockage ($G_1$) résulte de la soustraction entre la quantité de charges de référence ($Q_{réf}$) et entre les n quantités de charges ($Q_e$).

2. Dispositif selon la revendication 1, caractérisé en ce que les moyens assurant l'injection sous la première électrode de stockage ($G_1$) de la quantité de charges de référence ($Q_{réf}$) sont constitués par deux électrodes de transfert des charges ($G_{01}$, $G_{02}$) qui entourent cette première électrode de stockage, ces deux électrodes de transfert étant portées à des tensions différentes, et par une diode d'injection des charges (D), implantée dans le substrat semi-conducteur (1) à la suite de l'électrode de transfert portée à la tension la plus élevée $V_0$, cette diode d'injection étant sucessivement portée à une tension inférieure puis supérieure au potentiel de surface ($\phi_{réf}$) sous l'électrode de transfert ($G_{01}$) portée à la tension $V_0$.

3. Dispositif selon la revendication 2, caractérisé en ce que les moyens assurant le maintien d'un potentiel de surface constant sous la première électrode de stockage ($G_1$) et l'évacuation des charges en surplus sont constitués par les deux électrodes de transfert des charges ($G_{01}$, $G_{02}$) qui entourent cette première électrode de stockage, l'une de ces électrodes de transfert étant portée à la tension $V_0$ alors que l'autre électrode de transfert est portée à une tension inférieure à $V_0$, et par une électrode de stockage ($G_3$) ou une diode d'injection (D) a la suite de l'électrode de transfert portée à $V_0$, le potentiel de surface sous cette électrode de stockage ou sous cette diode étant supérieur au potentiel de surface sous l'électrode de transfert portée à la tension $V_0$.

4. Dispositif selon l'une des revendications 1, 2 ou 3, caractérisé en ce que le substrat semiconducteur (1) est faiblement dopé, de l'ordre de $5 . 10^{14}$ cm$^{-3}$.

5. Dispositif selon l'une des revendications 1 à 4, caractérisé en ce que les tensions $V_P$ et $V_0$ sont identiques.

**Patentansprüche**

1. Vorrichtung zur Uebertragung von Subtraktionsladungen und zur Erzeugung von Ladungsmengen vermittels welcher $n$ Ladungsmengen von einer Bezugsladungsmenge subtrahiert werden und eine den $n$ Ladungsmengen äquivalente Ladungsmenge erzeugt wird, dadurch gekennzeichnet, dass sie in einem Substrat, in welchem die Entleerungskapazitäten erheblich kleiner sind, als die Oxydkapazitäten, folgende Bauteile umfasst:

— eine erste Speicherelektrode ($G_1$), die an einem Punkt P an $n$ andere Speicherelektroden ($G_{21} \ldots G_{2n}$) elektrisch leitend angeschlossen ist;
— Mittel ($G_{01}$, $G_{02}$, D) zum Eingeben der Bezugsladungsmenge ($Q_{réf}$) unter der ersten Speicherelektrode vor der Ankunft der Ladungen unter den $n$ Speicherelektroden, während der Punkt P unter einer konstanten Spannung Vp liegt;
— Mittel ($G_{01}$, $G_{02}$, $G_3$, D) zur Aufrechterhaltung eines konstanten Oberflächenpotentials ($\phi_{réf}$) unter der ersten Speicherelektrode ($G_1$) bei der Ankunft der Ladungen ($Q_e$) unter den $n$ Speicherelektroden, während der Punkt P im Schwebezustand gehalten wird, sowie Mittel ($G_{01}$, $G_{02}$, $G_3$, D) zum Ableiten der überzähligen Ladungen, wodurch eine den unter den $n$ Elektroden empfangenen $n$ Ladungsmengen äquivalente Ladungsmenge ($Q_e$) erzeugt wird und wodurch erzielt wird, dass die unter der ersten Speicherelektrode ($G_1$) verbleibende Ladungsmenge ($Q_{réf} - Q_e$) das Ergebnis der Subtraktion zwischen der Bezugsladungsmenge ($Q_{réf}$) und zwischen den $n$ Ladungsmengen ($Q_e$) darstellt.

2. Vorrichtung nach Anspruch 1, dadurch gekennzeichnet, dass die Mittel zum Eingeben der Bezugsladungsmenge ($Q_{réf}$) unter der ersten Speicherelektrode ($G_1$) aus zwei Ladungsübertragungs-Elektroden ($G_{01}$, $G_{02}$) bestehen, welche diese erste Speicherelektrode umgeben und auf verschiedene Spannungen gebracht werden, sowie aus einer Ladungseingebediode (D), die in das Halbleitersubstrat (1) hinter der auf die höchste Spannung $V_0$ gebrachten Uebertragungselektrode eingelassen ist, wobei diese Eingebediode abwechselnd erst auf einer unter, sodann auf eine über dem unter der auf die Spannung $V_0$ gebrachten Uebertragungselektrode ($G_{01}$) vorliegenden Oberflächenpotential ($\phi_{réf}$) liegende Spannung gebracht wird.

3. Vorrichtung nach Anspruch 2, dadurch gekennzeichnet, dass die Mittel zur Aufrechterhaltung eines konstanten Oberflächenpotentials unter der ersten Speicherelektrode ($G_1$) und zum Ableiten der überzähligen Ladungen durch die beiden Ladungsübertragungselektroden ($G_{01}$, $G_{02}$) gebildet werden, welche diese erste Speicherelektrode umgeben, wobei eine dieser Uebertragungselektrode auf die Spannung $V_0$ und die andere Uebertragungselektrode auf eine unterhalb der Spannung $V_0$ liegende Spannung gebracht wird, sowie durch eine der auf die Spannung $V_0$ gebrachten Uebertragungselektrode nachgeschaltete Speicherelektrode ($G_2$) oder eine Eingebediode (D), während das Oberflächenpotential unter dieser Speicherelektrode oder unter dieser Diode höher ist, als das Oberflächenpotential unter der auf die Spannung $V_0$ gebrachten Uebertragungselektrode.

4. Vorrichtung nach einem der Ansprüche 1, 2 oder 3, dadurch gekennzeichnet, dass das Halbleitersubstrat (1) leicht dotiert ist, und zwar in der Grössenordnung von $5 \times 10^{14}$ cm$^{-3}$.

5. Vorrichtung nach einem der Ansprüche 1 bis 4, dadurch gekennzeichnet, dass die Spannungen $V_P$ und $V_0$ gleich sind.

**Claims**

1. A device for transferring subtraction loads and for generating load quantites ensuring the subtraction of $n$ load quantities from a reference load quantity, and the generating of a load quantity equivalent to said $n$ load quantities, characterized in that it comprises a substrate where the depletion capacities are substantially smaller than the oxide capacities:

— a first storing electrode ($G_1$) electrically connected at point P to $n$ other storing electrodes ($G_{21} \ldots G_{2n}$);
— means ($G_{01}$, $G_{02}$, D) for injecting under said first storing electrode the reference load quantity ($Q_{réf}$) prior to the arrival of the loads under said $n$ storing electrodes, while said point P is under a constant voltage $V_P$;
— means ($G_{01}$, $G_{02}$, $G_3$, D) for maintaining a constant surface potential ($\phi_{réf}$) under said first storage electrode ($G_1$) at the time of arrival of the loads ($Q_e$) under said $n$ storing electrodes while said point P is allowed to float, and means ($G_{01}$, $G_{02}$, $G_3$, D) for evacuating the surplus loads, whereby a load quantity ($Q_e$) equivalent to said $n$ load quantities arrived under said $n$ storing electrodes is generated, and whereby the load quantity ($Q_{réf} - Q_e$) remaining under said first storing electrode ($G_1$) results from the subtraction between said reference load quantity ($Q_{réf}$) and between said $n$ load quantities ($Q_e$).

2. A device according to claim 1, characterized in that said means for injecting under said first storing electrode ($G_1$) said reference load quantity ($Q_{réf}$) are constituted by two load transfer electrodes ($G_{01}$, $G_{02}$) surrounding said first storing electrode, said two transfer electrodes being brought to different voltages, and by a load injecting diode (D) implanted in the semiconductor substrate (1) behind that transfer electrode which is submitted to the highest voltage $V_0$, said injecting diode being successively brought to a voltage lower, then to a voltage higher, than said surface potential ($\phi_{réf}$) under the transfer electrode ($G_{01}$) brought to voltage $V_0$.

3. A device according to claim 2, characterized in that the means for maintaining a constant surface potential under said first storing electrode ($G_1$) and for evacuating said surplus loads are constituted by the two load transfer electrodes ($G_{01}$, $G_{02}$) which surround said first storing electrode, one of said transfer electrodes being brought to said voltage $V_0$, while the other transfer electrode is brought to a voltage lower than $V_0$, and by a storing electrode ($G_2$) or an injection diode (D) arranged behind said transfer electrode brought to voltage $V_0$, the surface potential under said storing electrode or under said diode being higher than the surface potential under the transfer electrode brought to voltage $V_0$.

4. A device according to one of claims 1, 2 or 3, characterized in that said semiconductor substrate (1) is slightly doped, ranging about 5 . $^{14}$ cm$^{-3}$.

5. A device according to one of claims 1 to 4, characterized in that said voltages $V_P$ and $V_0$ are identical.

FIG. 1a (t₁)

FIG. 1b (t₂)

FIG. 2

FIG. 3